# EUROPEAN PATENT APPLICATION

(11) **EP 4 432 811 A1**
(43) Date of publication of application: **18.09.2024**
(21) Application number: 24162843.7
(22) Date of filing: 12.03.2024
(51) Int. Cl.: H10N 10/13, F01N 5/02

(54) **GUIDE COVER AND THERMOELECTRIC POWER GENERATION UNIT WITH GUIDE COVER**

(30) Priority: 16.03.2023 JP 2023041591
(71) Applicant: KELK Ltd., Kanagawa 254-8543 (JP)
(72) Inventor: OBA, Masakazu, Kanagawa, 254-8543 (JP); KISHIZAWA, Toshihiko, Kanagawa, 254-8543 (JP)
(74) Representative: Flügel Preissner Schober Seidel

(57) **Abstract**

A guide cover 1 guides a high-temperature thermal fluid to a thermoelectric power generation unit, the guide cover 1 including: an outer cover 2 that is cylindrical; and an inner cover 4 disposed inside the outer cover 2, the inner cover 4 being cylindrical, in which at least a part of a wall of the inner cover 4 is inclined in such a manner that a cross-sectional area on an outlet side is narrower than a cross-sectional area on an inlet side of the high-temperature thermal fluid.

## Description

### CROSS-REFERENCE TO RELATED APPLICATION(S)

The present application claims priority to and incorporates by reference the entire contents of Japanese Patent Application No. 2023-041591 filed in Japan on March 16, 2023.

### BACKGROUND OF THE INVENTION

### 1. Field of the Invention

The present invention relates to a guide cover and a thermoelectric power generation unit with a guide cover.

### 2. Description of the Related Art

An example of a thermoelectric power generation device, in which a heat receiving plate is covered with a cover having a flame introduction port and a flame discharge port, is disclosed (see, for example, JP 2019-030159 A). In the technology described in JP 2019-030159 A, pin fins for diffusing flames and pin fins for absorbing heat of the diffused flames are arranged on a heat receiving surface.

The technology described in JP 2019-030159 A has a structure in which the cover covers the heat receiving plate, and the introduction port and the discharge port are arranged in a part of the cover. For this reason, there are many flames and the like reflected on the surface of the cover, and a few flames and the like enter the inside from the introduction port. As described above, there is room for improvement in efficiently recovering waste heat.

An aspect of the present invention aims to efficiently recover waste heat.

### SUMMARY OF THE INVENTION

It is an object of the present invention to at least partially solve the problems in the conventional technology.

According to an aspect of the present invention, a guide cover for guiding a high-temperature thermal fluid to a thermoelectric power generation unit comprises: an outer cover that is cylindrical; and an inner cover disposed inside the outer cover, the inner cover being cylindrical, wherein at least a part of a wall of the inner cover is inclined in such a manner that a cross-sectional area on an outlet side of the high-temperature thermal fluid is narrower than a cross-sectional area on an inlet side of the high-temperature thermal fluid.

Preferred embodiments of the above guide cover are defined in dependent claims 2 to 9.

In a preferred embodiment the outer cover and the inner cover are arranged in such a manner as to be movable without being restrained from each other.

In another preferred embodiment a lower end of the inner cover is positioned above a lower end of the outer cover in a vertical direction.

In another preferred embodiment there is a gap between the outer cover and the inner cover in a vertical cross-sectional view.

In another preferred embodiment the inner cover includes a first tubular portion whose cross-sectional area decreases in a vertical cross-sectional view as the first tubular portion extends from a lower side towards an upper side and a second tubular portion connected to an upper end of the first tubular portion, the second tubular portion having a constant cross-sectional area.

In another preferred embodiment the inner cover includes a first tubular portion whose cross-sectional area decreases in a vertical cross-sectional view as the first tubular portion extends from a lower side towards an upper side and a second tubular portion whose cross-sectional area increases in a vertical cross-sectional view as the second tubular portion extends from a lower side towards an upper side, the second tubular portion connected to an upper end of the first tubular portion.

In another preferred embodiment a vertical length of the second tubular portion is longer than a vertical length of the first tubular portion.

In another preferred embodiment the inner cover includes a first tubular portion whose cross-sectional area decreases as the first tubular portion extends from a lower side towards an upper side in a vertical cross-sectional view. In another preferred embodiment at least one of the outer cover or the inner cover has a round cross-sectional shape in a vertical cross-sectional view.

According to another aspect of the present invention, a thermoelectric power generation unit with a guide cover comprises the guide cover and a thermoelectric power generation unit.

The above and other objects, features, advantages and technical and industrial significance of this invention will be better understood by reading the following detailed description of presently preferred embodiments of the invention, when considered in connection with the accompanying drawings.

### BRIEF DESCRIPTION OF THE DRAWINGS

FIG. 1 is a cross-sectional view of a guide cover according to an embodiment;
FIG. 2 is a perspective view of the guide cover according to the embodiment;
FIG. 3 is a perspective view in which an inner cover is removed from FIG. 2;
FIG. 4 is a perspective view in which fins are removed from FIG. 2;
FIG. 5 is a cross-sectional view of a modification of the inner cover;
FIG. 6 is a cross-sectional view of a modification of the inner cover; and
FIG. 7 is a cross-sectional view of a modification of the inner cover.

### DETAILED DESCRIPTION OF THE PREFERRED EMBODIMENTS

Hereinafter, embodiments of the present invention will be described with reference to the drawings; however, the present invention is not limited thereto. Components of the embodiments described below can be combined as appropriate. Meanwhile, some of the components may not be used.

### Embodiments

### Thermoelectric Power Generation Unit

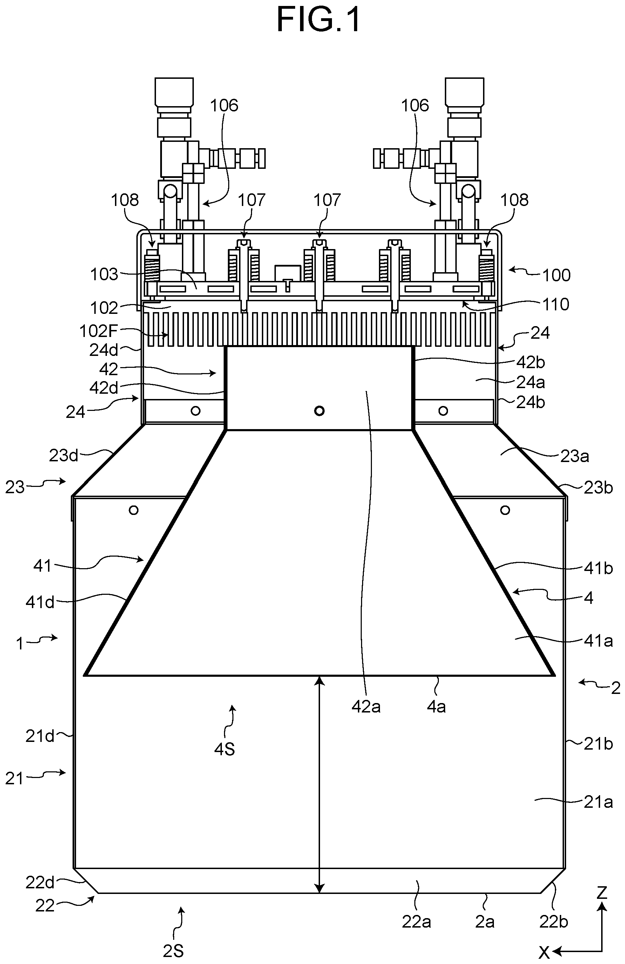

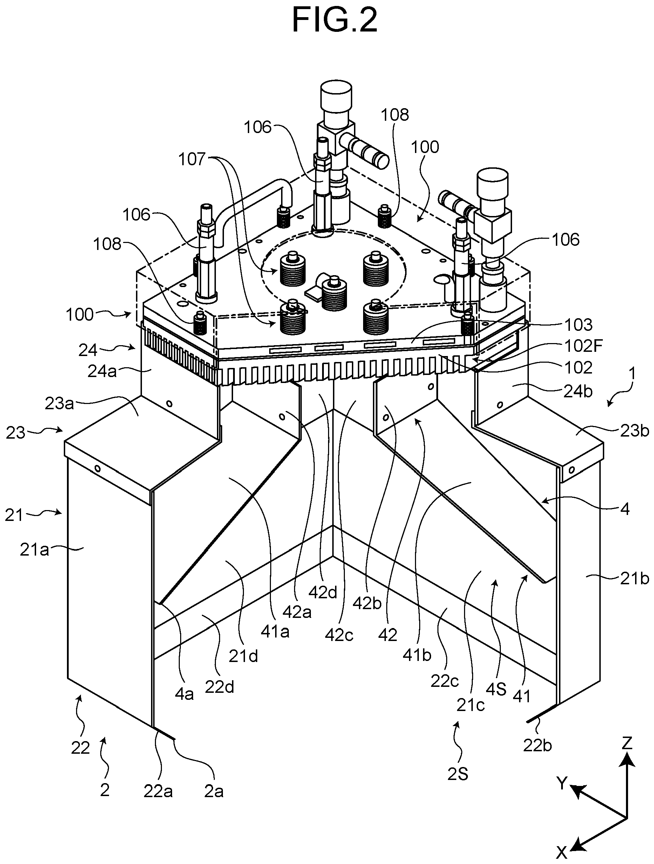

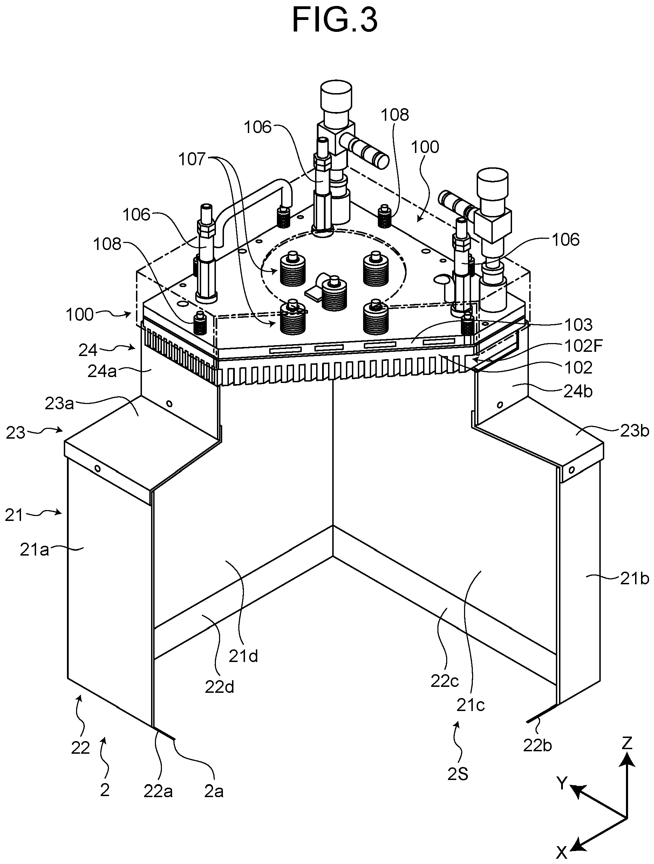

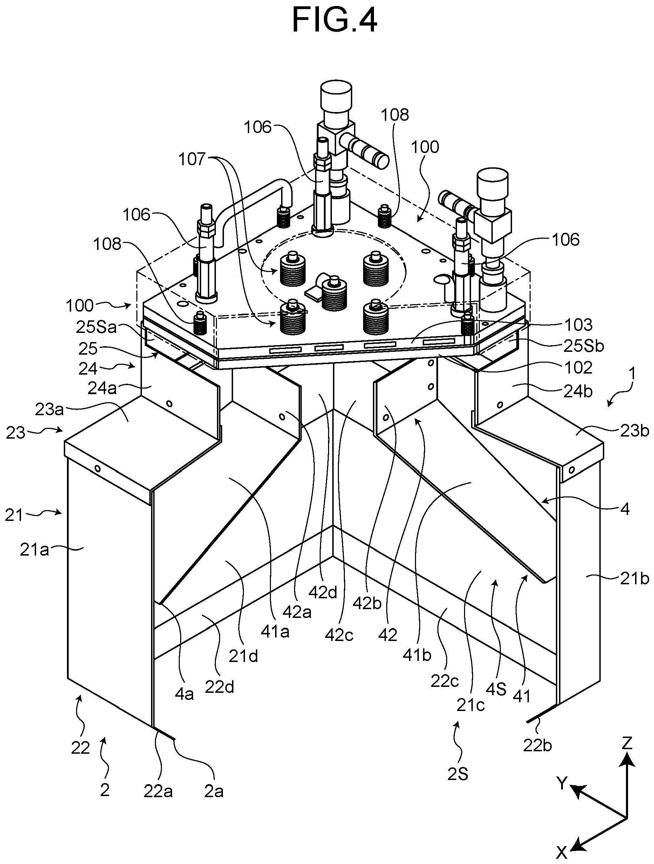

FIG. 1 is a cross-sectional view of a guide cover according to an embodiment. FIG. 2 is a perspective view of the guide cover according to the embodiment. FIG. 3 is a perspective view in which an inner cover is removed from FIG. 2. FIG. 4 is a perspective view in which fins are removed from FIG. 2. A guide cover 1 covers a thermoelectric power generation unit 100 attached above the heat source and is thereby used. The thermoelectric power generation unit 100 includes a thermoelectric power generation module 110, a heat receiving plate 102 that is a high-temperature heat transfer plate, and a cooling plate 103 that is a low-temperature heat transfer plate. Usually, cooling water is used as a fluid to flow to the cooling plate 103; however, the fluid is not limited thereto, and brine or gas may be used.

The thermoelectric power generation unit 100 is fastened by an attachment member 106, first fastening members 107, and second fastening members 108 in a state where the thermoelectric power generation module 110 is vertically sandwiched between the heat receiving plate 102 and the cooling plate 103.

The attachment member 106 is, for example, a hanging bolt for hanging and fixing thermoelectric power generation module 110 to an attachment object. The attachment member 106 is attached to the cooling plate 103 for hanging.

The first fastening members 107 are, for example, bolts for hanging and fixing the thermoelectric power generation module 110 from and to the attachment object. The first fastening members 107 are arranged in such a manner as to penetrate the thermoelectric power generation module 100, the heat receiving plate 102, and the cooling plate 103 in a state where the thermoelectric power generation module 110 is vertically sandwiched between the heat receiving plate 102 and the cooling plate 103.

The second fastening members 108 are bolts in which a spring that energizes the cooling plate 103 downward is disposed. The second fastening members 108 are arranged on an outer side of the thermoelectric power generation module 110 in a state where the thermoelectric power generation module 110 is vertically sandwiched between the heat receiving plate 102 and the cooling plate 103. The second fastening members 108 are arranged in such a manner as to penetrate the heat receiving plate 102 and the cooling plate 103.

The heat receiving plate 102 is disposed underneath the thermoelectric power generation module 110. The heat receiving plate 102 receives heat from a heat source and transfers the heat to the thermoelectric power generation module 110 with a small in-plane distribution of the temperature. The heat receiving plate 102 is made of a metal material having high thermal conductivity such as copper or aluminum. The heat receiving plate 102 is a rectangular plate-like member. A surface 2b of the heat receiving plate 102 receives heat from equipment serving as the heat source. The heat of the heat receiving plate 102 is conducted to the thermoelectric power generation module 110.

The heat receiving plate 102 may include pin fins 102F. The height position of an opening at the upper end in the vertical direction, which is an outlet of a high-temperature thermal fluid, is opened starting from either the bases of the pin fins 102F or the tips of the pin fins 102F.

The cooling plate 103 is installed to face and to be separated from the heat receiving plate 102 in the vertical direction. The cooling plate 103 is disposed on the thermoelectric power generation module 100. The cooling plate 103 cools one surface of the thermoelectric power generation module 100, whereby the power is efficiently generated while maintaining a temperature difference. The cooling plate 103 is made of a metal material having high thermal conductivity such as copper or aluminum. The cooling plate 103 is a rectangular plate-like member. The cooling plate 103 receives heat from the thermoelectric power generation module 110. The heat of the cooling plate 103 is cooled and dissipated to the surroundings of the guide cover 1.

### Guide Cover

The guide cover 1 is used for the thermoelectric power generation unit 100 that converts exhaust heat of flames, hot air, or the like generated in factory equipment into electricity. The guide cover 1 takes in flames or hot air and guides the flame or the hot air to the heat receiving plate 102 of the thermoelectric module 110 of the thermoelectric power generation unit 100. The guide cover 1 is formed in a vertically long chimney shape. The guide cover 1 is formed in a double cylindrical shape. The guide cover 1 includes an outer cover 2 and an inner cover 4.

The outer cover 2 is an outer tubular member that defines the outer shape of the guide cover 1. The outer cover 2 has a narrowed shape with a lower end 2a side bent inward. The lower end 2a of the outer cover 2 is an inlet 2S from which the high-temperature thermal fluid generated from the heat source flows in. An upper end of the outer cover 2 is an outlet through which the high-temperature thermal fluid generated from the heat source flows out to a side where the high-temperature thermal fluid is to be in contact with the thermoelectric power generation unit 100. An exhaust port 25 is formed on a side surface of the upper end of the outer cover 2.

The outer cover 2 includes a first tubular portion 21, a second tubular portion 22, a third tubular portion 23, and a fourth tubular portion 24. The first tubular portion 21, the second tubular portion 22, the third tubular portion 23, and the fourth tubular portion 24 are integrally connected to form the outer cover 2.

The first tubular portion 21 is the main body portion of the outer cover 2. The first tubular portion 21 has a rectangular cross-sectional shape as viewed in the Z axis direction. The first tubular portion 21 includes a wall 21a, a wall 21b, a wall 21c, and a wall 21d. The wall 21a, the wall 21b, the wall 21c, and the wall 21d are each formed of a rectangular plate material. The wall 21a and the wall 21c are arranged to be separated from each other in a Y axis direction and to face each other. The wall 21b and the wall 21c are arranged to be separated from each other in an X axis direction and to face each other. A first end of the wall 21a in the X axis direction is connected with the wall 21b. A first end of the wall 21b in the Y axis direction is connected with the wall 21c. A second end of the wall 21c in the X axis direction is connected with the wall 21d. A second end of the wall 21d in the Y axis direction is connected with the wall 21a.

The second tubular portion 22 is connected to a lower portion of the first tubular portion 21. The cross-sectional area of the second tubular portion 22 decreases as it extends downward. The second tubular portion 22 has a rectangular cross-sectional shape as viewed in the Z axis direction. The first tubular portion 22 includes a wall 22a, a wall 22b, a wall 22c, and a wall 22d. The wall 22a, the wall 22b, the wall 22c, and the wall 22d are each formed of a rectangular plate material. The wall 22a, the wall 22b, the wall 22c, and the wall 22d are arranged to be inclined with respect to the Z-axis direction. The wall 22a and the wall 22c are arranged to be separated from each other in the Y axis direction and to face each other. The wall 22b and the wall 22c are arranged to be separated from each other in the X axis direction and to face each other. A first end of the wall 22a in the X axis direction is connected with the wall 22b. A first end of the wall 22b in the Y axis direction is connected with the wall 22c. A second end of the wall 22c in the X axis direction is connected with the wall 22d. A second end of the wall 22d in the Y axis direction is connected with the wall 22a. A first end of the wall 22a in the Z axis direction is connected with the wall 21a. A first end of the wall 22b in the Z axis direction is connected with the wall 21b. A first end of the wall 22c in the Z axis direction is connected with the wall 21c. A first end of the wall 22d in the Z axis direction is connected with the wall 21d.

The third tubular portion 23 is connected to an upper portion of the first tubular portion 21. The cross-sectional area of the third tubular portion 23 decreases as it extends downward. The third tubular portion 23 has a rectangular cross-sectional shape as viewed in the Z axis direction. The first tubular portion 23 includes a wall 23a, a wall 23b, a wall 23c, and a wall 23d. The wall 23a, the wall 23b, the wall 23c, and the wall 23d are each formed of a rectangular plate material. The wall 23a, the wall 23b, the wall 23c, and the wall 23d are arranged to be inclined with respect to the Z-axis direction. The wall 23a and the wall 23c are arranged to be separated from each other in the Y axis direction and to face each other. The wall 23b and the wall 23c are arranged to be separated from each other in the X axis direction and to face each other. A first end of the wall 23a in the X axis direction is connected with the wall 23b. A first end of the wall 23b in the Y axis direction is connected with the wall 23c. A second end of the wall 23c in the X axis direction is connected with the wall 23d. A second end of the wall 23d in the Y axis direction is connected with the wall 23a. A second end of the wall 23a in the Z axis direction is connected with the wall 21a. A second end of the wall 23b in the Z axis direction is connected with the wall 21b. A second end of the wall 23c in the Z axis direction is connected with the wall 21c. A second end of the wall 23d in the Z axis direction is connected with the wall 21d.

The fourth tubular portion 24 is connected to an upper portion of the third tubular portion 23. The fourth tubular portion 24 has a rectangular cross-sectional shape as viewed in the Z axis direction. The fourth tubular portion 24 includes a wall 24a, a wall 24b, a wall 24c, and a wall 24d. The wall 24a, the wall 24b, the wall 24c, and the wall 24d are each formed of a rectangular plate material. The wall 24a, the wall 24b, the wall 24c, and the wall 24d are arranged to be inclined with respect to the Z-axis direction. The wall 24a and the wall 24c are arranged to be separated from each other in the Y axis direction and to face each other. The wall 24b and the wall 24c are arranged to be separated from each other in the X axis direction and to face each other. A first end of the wall 24a in the X axis direction is connected with the wall 24b. A first end of the wall 24b in the Y axis direction is connected with the wall 24c. A second end of the wall 24c in the X axis direction is connected with the wall 24d. A second end of the wall 24d in the Y axis direction is connected with the wall 24a. A second end of the wall 24a in the Z axis direction is connected with the wall 23a. A second end of the wall 24b in the Z axis direction is connected with the wall 23b. A second end of the wall 24c in the Z axis direction is connected with the wall 23c. A second end of the wall 24d in the Z axis direction is connected with the wall 23d.

An opening serving as the exhaust port 25 for discharging air to the outside is formed in the fourth tubular portion 24. More specifically, an opening serving as an exhaust port 25Sa is formed in the wall 24a. The wall 24b is formed with an opening serving as an exhaust port 25Sb. The wall 24c is formed with an opening serving as an exhaust port 25Sc. The wall 24d is formed with an opening serving as an exhaust port 25Sd.

The inner cover 4 is an inner tubular member disposed inside the outer cover 2. The inner cover 4 is inclined in a direction towards the center portion of the heat receiving plate 102 of the thermoelectric power generation module 110 of the thermoelectric power generation unit 100. A lower end 4a of the inner cover 4 is positioned above the lower end 2a of the outer cover 2. A space above the inlet 2S of the outer cover 2 and below an inlet 4S of the inner cover 4 serves as a flame introduction portion. The lower end 4a of the inner cover 4 is the inlet 4S into which the high-temperature thermal fluid generated from the heat source flows in. In the inner cover 4, at least a part of the walls is inclined in such a manner that the cross-sectional area on the outlet side is narrower than the cross-sectional area on the inlet side of the high-temperature thermal fluid. The opening area of the inlet 4S of the inner cover 4 is larger than the opening area of the outlet. The lower end 4a of the inner cover 4 is positioned above the lower end 2a of the outer cover 2 by a height H1.

The inner cover 4 includes a first tubular portion 41 and a second tubular portion 42. The first tubular portion 41 and the second tubular portion 42 are integrally connected to form the inner cover 4.

The first tubular portion 41 is the main body portion of the inner cover 4. The cross-sectional area of the first tubular portion 41 decreases as it extends upward. The first tubular portion 41 has a rectangular cross-sectional shape as viewed in the Z axis direction. The first tubular portion 41 includes a wall 41a, a wall 41b, a wall 41c, and a wall 41d. The wall 41a, the wall 41b, the wall 41c, and the wall 41d are each formed of a rectangular plate material. The wall 41a, the wall 41b, the wall 41c, and the wall 41d are arranged to be inclined with respect to the Z-axis direction. The wall 41a and the wall 41c are arranged to be separated from each other in the Y axis direction and to face each other. The wall 41b and the wall 41c are arranged to be separated from each other in the X axis direction and to face each other. A first end of the wall 41a in the X axis direction is connected with the wall 41b. A first end of the wall 41b in the Y axis direction is connected with the wall 41c. A second end of the wall 41c in the X axis direction is connected with the wall 41d. A second end of the wall 41d in the Y axis direction is connected with the wall 41a.

The second tubular portion 42 is connected to an upper portion of the first tubular portion 41. The second tubular portion 42 has a shorter length in the Z-axis direction than that of the first tubular portion 41. In the embodiment, the length of the second tubular portion 42 in the Z axis direction is less than or equal to a half of the length of the first tubular portion 41 in the Z axis direction. The second tubular portion 42 has a rectangular cross-sectional shape as viewed in the Z axis direction. The first tubular portion 42 includes a wall 42a, a wall 42b, a wall 42c, and a wall 42d. The wall 42a, the wall 42b, the wall 42c, and the wall 42d are each formed of a rectangular plate material. The wall 42a and the wall 42c are arranged to be separated from each other in the Y axis direction and to face each other. The wall 42b and the wall 42c are arranged to be separated from each other in the X axis direction and to face each other. A first end of the wall 42a in the X axis direction is connected with the wall 42b. A first end of the wall 42b in the Y axis direction is connected with the wall 42c. A second end of the wall 42c in the X axis direction is connected with the wall 42d. A second end of the wall 42d in the Y axis direction is connected with the wall 42a. A second end of the wall 42a in the Z axis direction is connected with the wall 41a. A second end of the wall 42b in the Z axis direction is connected with the wall 41b. A second end of the wall 42c in the Z axis direction is connected with the wall 41c. A second end of the wall 42d in the Z axis direction is connected with the wall 41d.

The second tubular portion 42 is formed with an opening serving as an exhaust port (not illustrated) for discharging air to the outside. More specifically, an opening serving as an exhaust port is formed in each of the wall 42a, the wall 42b, the wall 42c, and the wall 42d.

A space between the outer cover 2 and the inner cover 4 thus structured is a space through which high-temperature air and flames flow.

### Effects

As described above, in the embodiment, in the inner cover 4, at least a part of the walls is inclined in such a manner that the cross-sectional area on the outlet side is narrower than the cross-sectional area on the inlet side of the high-temperature thermal fluid. In the embodiment, the heat taken into the guide cover 1 is burnt in the guide cover 1. As a result, the embodiment can suppress diffusion of combustion heat into the atmosphere. In the embodiment, the heat taken into the guide cover 1 without being diffused rises by buoyancy in the guide cover 1 due to the chimney effect. In the embodiment, the heat flowing between the outer cover 2 and the inner cover 4 provides a heat insulation effect. The embodiment can increase the combustion efficiency in the inner cover 4, thereby increasing the temperature. The embodiment can efficiently recover waste heat.

In the embodiment, there is a gap between the outer cover 2 and the inner cover 4 in a vertical cross-sectional view. In the embodiment, the heat flowing between the outer cover 2 and the inner cover 4 can provide a heat insulation effect. The embodiment can increase the combustion efficiency in the inner cover 4, thereby increasing the temperature.

In the embodiment, the inner cover 4 includes the first tubular portion 41 whose cross-sectional area decreases in a vertical cross-sectional view as it extends from the lower side towards the upper side and the second tubular portion 42 connected to the upper end of the first tubular portion 41 and having a constant cross-sectional area. In the embodiment, the heat rising due to buoyancy in the guide cover 1 can be collected to the center portion of the heat receiving plate 102 of the thermoelectric power generation module 110 by the inclination of the inner cover 4. In the embodiment, in a case where the inclination of the inner cover 4 is made steep, the opening area on the outlet side is reduced, whereby the heat spot can be controlled. In the embodiment, the temperature distribution of the heat receiving plate 102 of the thermoelectric power generation module 110 can be made uniform.

In the embodiment, the outer cover 2 and the inner cover 4 are arranged in a movable manner without being restrained from each other. According to the embodiment, the outer cover 2 or the inner cover 4 can be freely deformed without being restrained to each other. According to the embodiment, it is possible to suppress the temperature of the heat receiving plate 102 of the thermoelectric power generation module 110 to be nonuniform.

In the embodiment, the lower end 4a of the inner cover 4 is positioned above the lower end 2a of the outer cover 2 in the vertical direction. According to the embodiment, flames, hot air, or the like can be taken into the space between the lower end 4a of the inner cover 4 and the lower end 2a of the outer cover 2.

As described above, the embodiment can control flames and transfer necessary heat to a predetermined place while increasing combustion efficiency. According to the embodiment, the thermoelectric power generation module 110 can be penetrated with a uniform temperature distribution.

In the embodiment, since it is possible to prevent the temperature from becoming too high locally, it is possible to extend the power generation life and to increase the amount of power generation.

According to the embodiment, it is possible to efficiently recover waste heat without discarding high-temperature thermal fluids including flames and hot blasts generated by an afterburner or the like.

### First Modification

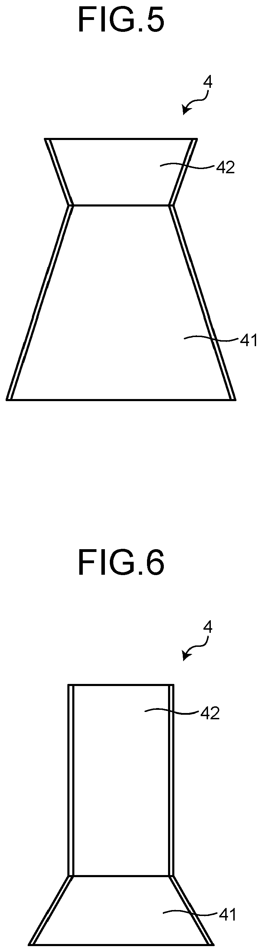

FIG. 5 is a cross-sectional view of a modification of the inner cover. An inner cover 4 includes, a first tubular portion 41 whose cross-sectional area decreases in a vertical cross-sectional view as it extends from the lower side towards the upper side and a second tubular portion 42 that is connected to an upper end of the first tubular portion 41 and whose cross-sectional area increases as it extends from the lower side towards the upper side. Four walls of the second tubular portion 42 are arranged to be inclined with respect to the Z-axis direction. Although the inner cover 4 is illustrated in FIG. 5, the outer cover 2 may have the shape illustrated in FIG. 5. The same applies also to the following modifications.

### Second Modification

FIG. 6 is a cross-sectional view of a modification of the inner cover. A second tubular portion 42 has a longer length in the Z-axis direction than that of a first tubular portion 41. In FIG. 6, the length of the second tubular portion 42 in the Z axis direction is twice or more than the length of the first tubular portion 41 in the Z axis direction. In the inner cover 4 illustrated in FIG. 6, the second tubular portion 42 functions as the main body portion.

### Third Modification

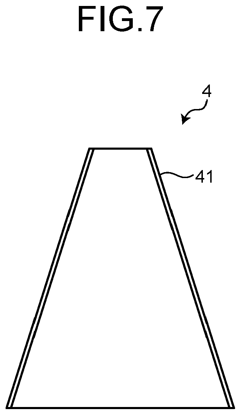

FIG. 7 is a cross-sectional view of a modification of the inner cover. An inner cover 4 includes only a first tubular portion 41. According to the modification, the inner cover 4 can have a simpler structure.

### Other Modifications

In the above description, the outer cover 2 and the inner cover 4 have been described as having a rectangular cross-sectional shape in the Z-axis direction; however, it is not limited thereto. At least one of the outer cover 2 or the inner cover 4 may have a round cross-sectional shape in the Z-axis direction. In this case, a cross-sectional shape of the thermoelectric power generation unit 100 in the Z-axis direction is preferably a round shape.

In order to make the position of the lower end of the inner cover 4 variable in the vertical direction with respect to the position of the lower end of the outer cover 2, for example, the first tubular portion 41 and the second tubular portion may be attached by screws to make them detachable, whereby the attachment position in the height direction may be made variable among several stages, or bellows that is stretchable may be included at a part of the first tubular portion 41 or the second tubular portion 42 to make the height position variable.

According to an aspect of the present invention, waste heat can be efficiently recovered.

Although the invention has been described with respect to specific embodiments for a complete and clear disclosure, the appended claims are not to be thus limited but are to be construed as embodying all modifications and alternative constructions that may occur to one skilled in the art that fairly fall within the basic teaching herein set forth.

## Claims

1. A guide cover (1) for guiding a high-temperature thermal fluid to a thermoelectric power generation unit (100), the guide cover (1) comprising:
an outer cover (2) that is cylindrical; and
an inner cover (4) disposed inside the outer cover (2), the inner cover (4) being cylindrical,
wherein at least a part of a wall of the inner cover (4) is inclined in such a manner that a cross-sectional area on an outlet side of the high-temperature thermal fluid is narrower than a cross-sectional area on an inlet (4S) side of the high-temperature thermal fluid.

2. The guide cover (1) according to claim 1,
wherein the outer cover (2) and the inner cover (4) are arranged in such a manner as to be movable without being restrained from each other.

3. The guide cover (1) according to claim 1 or 2,
wherein a lower end of the inner cover (4) is positioned above a lower end of the outer cover (2) in a vertical direction.

4. The guide cover (1) according to any of claims 1 to 3,
wherein there is a gap between the outer cover (2) and the inner cover (4) in a vertical cross-sectional view.

5. The guide cover (1) according to any of claims 1 to 4,
wherein the inner cover (4) includes: a first tubular portion (41) whose cross-sectional area decreases in a vertical cross-sectional view as the first tubular portion (41) extends from a lower side towards an upper side; and a second tubular portion (42) connected to an upper end of the first tubular portion (41), the second tubular portion (42) having a constant cross-sectional area.

6. The guide cover (1) according to any of claims 1 to 4,
wherein the inner cover (4) includes: a first tubular portion (41) whose cross-sectional area decreases in a vertical cross-sectional view as the first tubular portion (41) extends from a lower side towards an upper side; and a second tubular portion (42) whose cross-sectional area increases in a vertical cross-sectional view as the second tubular portion (42) extends from a lower side towards an upper side, the second tubular portion (42) connected to an upper end of the first tubular portion (41).

7. The guide cover (1) according to claim 5 or 6,
wherein a vertical length of the second tubular portion (42) is longer than a vertical length of the first tubular portion (41).

8. The guide cover (1) according to any of claims 1 to 7,
wherein the inner cover (4) includes a first tubular portion (41) whose cross-sectional area decreases as the first tubular portion (41) extends from a lower side towards an upper side in a vertical cross-sectional view.

9. The guide cover (1) according to any of claims 1 to 8,
wherein at least one of the outer cover (2) or the inner cover (4) has a round cross-sectional shape in a vertical cross-sectional view.

10. A thermoelectric power generation unit (100) with a guide cover (1) comprising:
the guide cover (1) according to any one of claims 1 to 9; and
a thermoelectric power generation unit (100).
